# EUROPEAN PATENT APPLICATION

(11) **EP 2 063 198 A1**
(43) Date of publication of application: **27.05.2009**
(21) Application number: 07120775.7
(22) Date of filing: 15.11.2007
(51) Int. Cl.: F24J 2/08, H01L 31/052

(54) **Fresnel zone lens with grid**

(71) Applicant: Atomic Energy Council - Institute of Nuclear Energy Research, Lungtan, Taoyuan, Taiwan (TW)
(72) Inventor: Shin, Hwa-Yuh ATOMIC ENERGY COUNCIL -, Longtan Shiang, Taoyuan 325 (TW); Kuo, Cherng-Tsong ATOMIC ENERGY COUNCIL -, Longtan Shiang, Taoyuan 325 (TW); Kuo, Hung-Zen ATOMIC ENERGY COUNCIL -, Longtan Shiang, Taoyuan 325 (TW); Chiu, Hung-Sheng ATOMIC ENERGY COUNCIL -, Longtan Shiang, Taoyuan 325 (TW); Hong, Hwen-Fen ATOMIC ENERGY COUNCIL -, Longtan Shiang, Taoyuan 325 (TW)
(74) Representative: Beck & Rössig European Patent Attorneys

(57) **Abstract**

There is disclosed a perfectly plain Fresnel zone lens. The perfectly plain Fresnel zone lens includes a plurality of focusing units and a grid formed together with the focusing units by injection molding for example. The grid consists a plurality of cells. Each of the focusing units is disposed in a related one of the cells.

## Description

### BACKGROUND OF INVENTION

### 1. FIELD OF INVENTION

The present invention relates to a Fresnel zone lens and, more particularly, to a Fresnel zone lens formed with a grid.

### 2. RELATED PRIOR ART

Solar cells are popular for being environmentally friendly and economic in use. The efficiencies of solar cells are becoming higher and higher while the prices are becoming lower and lower. Therefore, solar cells are getting more and more attention. Solar cells need focusing elements. The focusing elements can be classified into refraction-type lenses, reflection-type lenses and combination-type lenses. The refraction-type lenses include Fresnel zone lenses.

Fresnel zone lenses include a flat configuration that is thin and light. It is therefore difficult to ensure the plainness of a Fresnel zone lens in the production and use, particularly when a large size is preferred. The efficiency of the focusing of light would be jeopardized should a Fresnel zone lens is not plain. Accordingly, the quality of a solar cell in which the Fresnel zone lens is used would be compromised. The Fresnel zone lenses are limited to small sizes since it is particularly difficult to ensure the plainness of a Fresnel zone lens in the production and use if a large size is preferred.

The present invention is therefore intended to obviate or at least alleviate the problems encountered in prior art.

### SUMMARY OF INVENTION

It is the primary objective of the present invention to provide a large and plain Fresnel zone lens.

The invention provides a Fresnel lens according to claim 1. Advantageous embodiments are laid down in further claims.

To achieve the foregoing objective, a Fresnel zone lens includes a grid formed together with a plurality of focusing units. The grid includes a plurality of cells. Each of the focusing units is disposed in a related one of the cells.

Other objectives, advantages and features of the present invention will become apparent from the following description referring to the drawings.

### BRIEF DESCRIPTION OF DRAWINGS

The present invention will be described via detailed illustration of the two embodiments referring to the drawings.

Fig. 1 is a top view of a Fresnel zone lens according to the preferred embodiment of the present invention.

Fig. 2 is a perspective view of the Fresnel zone lens shown in Fig. 1.

### DETAILED DESCRIPTION OF PREFERRED EMBODIMENT

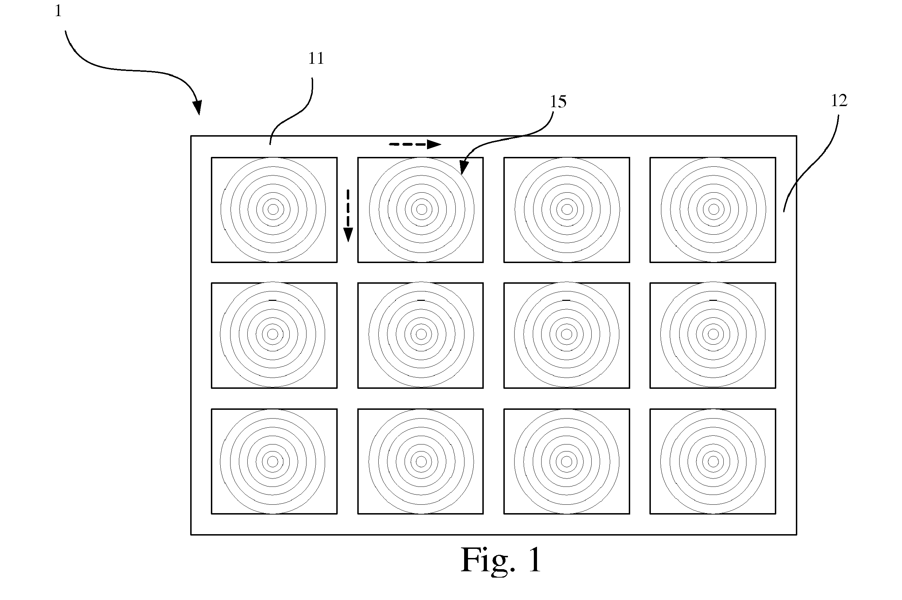

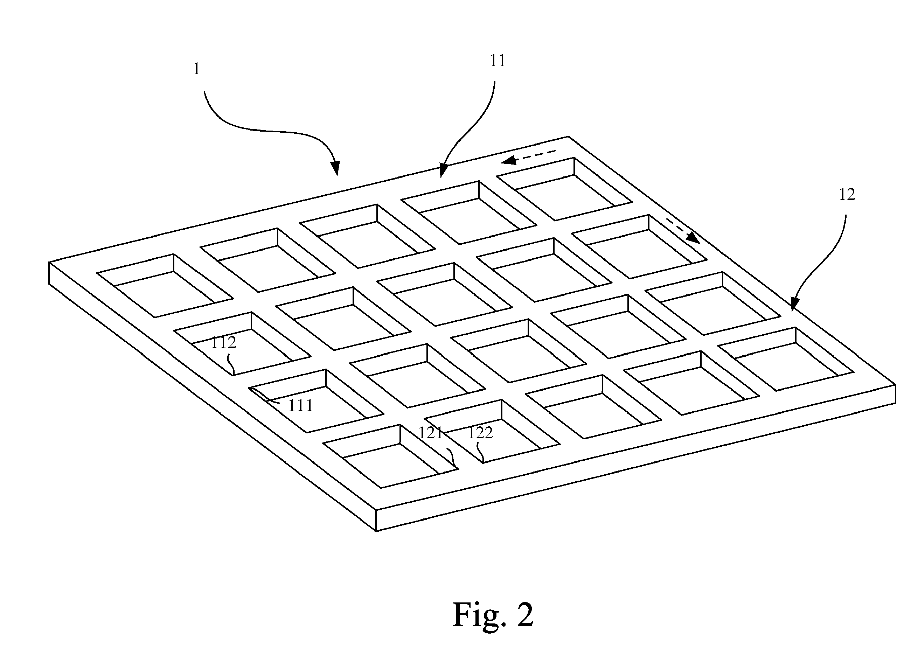

Referring to Figs. 1 and 2, a Fresnel lens 1 includes a grid and a plurality of focusing units 15 according to the preferred embodiment of the present invention.

The grid consists of a plurality of ribs 11 extended in a first direction and a plurality of ribs 12 extended in a second direction perpendicular to the first direction. The ribs 11 intersect the ribs 12 at points 14 so that a plurality of cells are defined. Each of the cells includes four walls 111, 112, 121 and 122. The walls 111 and 112 are perpendicular to the walls 121 and 122.

Each of the focusing units 15 is disposed in a related one of the cells. The focusing units 15 will not be described in detail for being conventional. However, it should be noted that the focusing units 15 are formed together with the grid by injection molding for example.

The grid includes square cells in the preferred embodiment. The grid may however include other polygonal cells such as hexagonal cells in another embodiment. Moreover, the grid may include circular cells in another embodiment.

The problems addressed in the related prior art are overcome by the present invention. The Fresnel zone lens according to the present invention is perfectly plain for including the grid for reinforcement. A Fresnel zone lens of a large size is therefore possible. Moreover, the cost of the Fresnel zone lens is low because the focusing units are formed together with the grid.

The present invention has been described via the detailed illustration of the preferred embodiment. Those skilled in the art can derive variations from the preferred embodiment without departing from the scope of the present invention. Therefore, the preferred embodiment shall not limit the scope of the present invention defined in the claims.

## Claims

1. A Fresnel zone lens comprising:
a grid comprising a plurality of cells; and
a plurality of focusing units (15) each disposed in a related one of the cells.

2. The Fresnel zone lens according to claim 1, wherein the cells are polygonal.

3. The Fresnel zone lens according to claim 2, wherein the cells are square.

4. The Fresnel zone lens according to one of claims 1 to 3, wherein the grid consists of a first group of ribs (11) and a second group of ribs (12) intersecting the first group of ribs, thus forming the cells.

5. The Fresnel zone lens according to claim 4, wherein the first group of ribs is perpendicular to the second group of ribs.

6. The Fresnel zone lens according to one of claims 1 to 5, wherein the grid and the focusing units (15) are integrally formed together.

7. Solar cell comprising a Fresnel zone lens according to one of claims 1 to 6.
